# EUROPEAN PATENT SPECIFICATION

(11) **EP 4 391 781 B1**
(45) Date of publication and mention of the grant of the patent: **21.01.2026**
(21) Application number: 21966350.7
(22) Date of filing: 30.11.2021
(51) Int. Cl.: H10N 30/853, H10N 30/076, H10N 30/079

(54) **FILM STRUCTURE, METHOD FOR PRODUCING FILM STRUCTURE AND APPARATUS FOR PRODUCING FILM STRUCTURE**
FILMSTRUKTUR, VERFAHREN ZUR HERSTELLUNG EINER FILMSTRUKTUR UND VORRICHTUNG ZUR HERSTELLUNG EINER FILMSTRUKTUR
STRUCTURE DE FILM, PROCÉDÉ DE PRODUCTION DE STRUCTURE DE FILM ET APPAREIL DE PRODUCTION DE STRUCTURE DE FILM

(43) Date of publication of application: 26.06.2024
(73) Proprietor: I-PEX Piezo Solutions Inc., Ube-shi, Yamaguchi 755-0152 (JP)
(72) Inventor: KONISHI, Akio, Ube-shi, Yamaguchi 755-0152 (JP); IIZUKA, Takeshi, Ube-shi, Yamaguchi 755-0152 (JP); KANAMORI, Hiroaki, Ube-shi, Yamaguchi 755-0152 (JP)
(74) Representative: Kraus & Lederer PartGmbB
(86) International application number: PCT/JP2021/043952
(87) International publication number: WO 2023/100266

(56) References cited:
- WO-A1-2020/026735
- WO-A1-2020/179210
- WO-A1-2020/179210
- JP-A- 2013 168 530
- JP-A- 2019 216 181
- JP-A- 2019 216 181
- US-A1- 2019 372 543

## Description

### TECHNICAL FIELD

The present invention relates to a film structure, a method for producing the film structure, and an apparatus for producing the film structure.

### BACKGROUND ART

In today's Internet of Things (IoT) era, where all kinds of things are connected to the Internet, sensors play an important role. Particularly, a micro electro mechanical system (MEMS) sensor technique using a piezoelectric material such as lead zirconate titanate (PZT) has been developed and widely applied to various applications such as a gyro sensor for autonomous driving, a piezoelectric microphone, and a high-frequency filter and vibration power generation element for 5G communication.

With the development of IoT technique, such a MEMS sensor technique using a piezoelectric material is required to be smaller, thinner, and higher in sensitivity year by year, and a technique has been proposed to obtain a piezoelectric material as a thin film single crystal by epitaxial growth.

For example, Patent Literature 1 discloses a film structure including a substrate, a buffer film formed on the substrate and having a tetragonal crystal structure containing zirconia, a metal film formed on the buffer film and containing an epitaxially grown platinum group element, and a film formed on the metal film and containing epitaxially grown Sr(Ti₁₋ₓ, Ruₓ)O₃ (0 ≤ x ≤ 1). Patent Literature 1 also discloses a film structure obtained by further forming a single-crystallized piezoelectric film and a conductive film on the film containing epitaxially grown Sr(Ti₁₋ₓ, Ruₓ)O₃.

A film bulk acoustic resonator (FBAR) is known as a device using a piezoelectric film. Generally, the FBAR includes, on a substrate, a lower electrode, a piezoelectric film, and an upper electrode in this order, and a void (an air gap) is formed below the lower electrode. For example, as described in Patent Literature 2, the void is formed by etching a substrate from a back surface or etching a sacrificial layer provided on a front surface of the substrate.

However, it is difficult to improve crystallinity of the piezoelectric film formed on the lower electrode of the FBAR. Therefore, for example, Patent Literature 3 discloses a method of forming a piezoelectric film with excellent crystallinity by epitaxially growing a piezoelectric film on different types of substrate and transferring the piezoelectric film onto a substrate with a void formed thereon.

### PRIOR ART DOCUMENTS

### PATENT LITERATURES

Patent Literature 1: WO2020/179210 A1
Patent Literature 2: JP2019-153858A
Patent Literature 3: JP2007-6001A

### SUMMARY OF INVENTION

### OBJECT TO BE ACHIEVED BY THE INVENTION

As disclosed in Patent Literature 1, when each film such as a piezoelectric film provided in the film structure is single-crystallized, characteristics of the device are improved. However, there is no known film structure which has a void between a substrate and an electrode film and in which each film provided in the film structure is single-crystallized.

An object of the present invention is to provide a film structure that can be used to produce a film structure in which each film is single-crystallized and which has a void between a substrate and an electrode film. Further, an object of the present invention is to provide a method for producing the film structure, and an apparatus for producing the film structure.

### MEANS FOR ACHIEVING THE OBJECT

As a result of intensive studies, the present inventors have found that the above problems can be solved by the following means.
(1) A film structure including a first film structure comprising:
   a substrate; a zirconia-containing film; a sacrificial layer; and a piezoelectric film, in this order, in which
   the substrate, the zirconia-containing film, the sacrificial layer, and the piezoelectric film are each single-crystallized, and
   the sacrificial layer is configured to be selectively removed from the first film structure.
(2) The film structure according to (1), further including: an electrode film between the piezoelectric film and the sacrificial layer.
(3) The film structure according to (1) or (2), wherein the piezoelectric film contains at least one selected from the group consisting of lead zirconate titanate, barium titanate, bismuth ferrite, aluminum nitride, lithium niobate, potassium sodium niobate, and lithium tantalate.
(4) The film structure according to (2), wherein the electrode film is single-crystallized.
(5) The film structure according to any one of (1) to (4), wherein the sacrificial layer contains at least one selected from the group consisting of strontium ruthenium oxide, magnesium oxide, strontium titanate, chromium, gold, and titanium.
(6) The film structure according to (2) or (4), wherein the electrode film contains at least one selected from the group consisting of platinum, copper, ruthenium, rhodium, palladium, osmium, molybdenum, and iridium.
(7) The film structure according to (2), (4), or (6), wherein the electrode film is thicker than the sacrificial layer.
(8) The film structure according to any one of (1) to (7), wherein the sacrificial layer has a thickness of 10 nm to 70 nm.
(9) The film structure according to any one of (1) to (8), further including: a second electrode film between the zirconia-containing film and the sacrificial layer.
(10) The film structure according to (9), wherein the second electrode film is single-crystallized.
(11) A method for producing the film structure according to any one of (1) to (10), the method including:
   preparing a substrate; and
   forming, on the substrate, a zirconia-containing film, a sacrificial layer, and a piezoelectric film in this order, wherein
   a film forming temperature of the sacrificial layer is 565°C to 665°C.
(12) An apparatus for producing the film structure according to any one of (1) to (10), the apparatus including:
   a film forming device A configured to form a zirconia-containing film; a film forming device B configured to form a sacrificial layer; and a film forming device C configured to form a piezoelectric film, wherein
   the apparatus includes a controller configured to control the film forming device A, the film forming device B, and the film forming device C.

### EFFECTS OF INVENTION

According to the present invention, a film structure that can be used to produce a film structure in which each film is single-crystallized and which has a void between a substrate and an electrode film can be provided. Further, according to the present invention, a method for producing the film structure, and an apparatus for producing the film structure can be provided.

### BRIEF DESCRIPTION OF DRAWINGS

FIG. 1 is a cross-sectional view of an example of a film structure.
FIG. 2 is a cross-sectional view of an example of the film structure.
FIG. 3 is a cross-sectional view of an example of the film structure.
FIG. 4 is a cross-sectional view of a film structure having a void formed by selectively removing a sacrificial layer from the film structure in FIG. 2.
FIG. 5 is a cross-sectional view of a film structure having a void formed by selectively removing a sacrificial layer from the film structure in FIG. 3.
FIG. 6 is a graph showing a θ-2θ spectrum of a film structure in Example 1, which is obtained by an XRD method.
FIG. 7 is a graph showing a θ-2θ spectrum of the film structure in Example 1, which is obtained by the XRD method.
FIG. 8 is a graph showing a θ-2θ spectrum of a film structure in Comparative Example 4, which is obtained by the XRD method.
FIG. 9 is a graph showing a θ-2θ spectrum of the film structure in Comparative Example 4, which is obtained by the XRD method.
FIG. 10 is a diagram showing an X-ray diffraction pattern of a piezoelectric film of the film structure in Example 1, which is obtained by Φ scan.

### EMBODIMENT FOR CARRYING OUT THE INVENTION

An embodiment of the present invention will be described below, but the present invention is not limited thereto. In order to make the description more clear, the drawings may be schematically illustrated with respect to a width, thickness, shape, and the like of each part as compared with the embodiment, but are merely examples and do not limit the interpretation of the present invention.

In the present description and each drawing, elements same as those described above in relation to the previously shown drawings are denoted by the same reference numerals, and detailed descriptions may be omitted as appropriate.

### <Film Structure>

A film structure of the present invention includes
a substrate, a zirconia-containing film, a sacrificial layer, and a piezoelectric film in this order, in which
the substrate, the zirconia-containing film, the sacrificial layer, and the piezoelectric film are each single-crystallized, and
the sacrificial layer is able to be selectively removed.

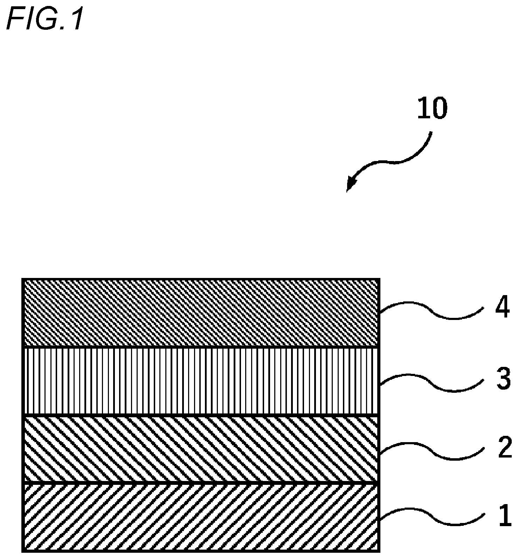

FIG. 1 is a cross-sectional view of an example of the film structure of the present invention.

The film structure 10 in FIG. 1 includes a substrate 1, a zirconia-containing film 2, a sacrificial layer 3, and a piezoelectric film 4 in this order.

The substrate 1, the zirconia-containing film 2, the sacrificial layer 3, and the piezoelectric film 4 are each single-crystallized.

In FIG. 1, the substrate 1 and the zirconia-containing film 2 are in contact with each other. The film structure of the present invention may include another film between the substrate and the zirconia-containing film, and the substrate and the zirconia-containing film are preferably in contact with each other (no other film is present therebetween).

In FIG. 1, the sacrificial layer 3 and the piezoelectric film 4 are in contact with each other. The film structure of the present invention may include another film between the sacrificial layer and the piezoelectric film. For example, an electrode film (also referred to as a first electrode film) may be provided between the sacrificial layer and the piezoelectric film.

In FIG. 1, the zirconia-containing film 2 and the sacrificial layer 3 are in contact with each other. The film structure of the present invention may include another film between the zirconia-containing film and the sacrificial layer. For example, an electrode film (also referred to as a "second electrode film") may be provided between the zirconia-containing film and the sacrificial layer.

The film structure of the present invention includes the substrate, the zirconia-containing film, the sacrificial layer, and the piezoelectric film in this order, and may include other film in addition to these.

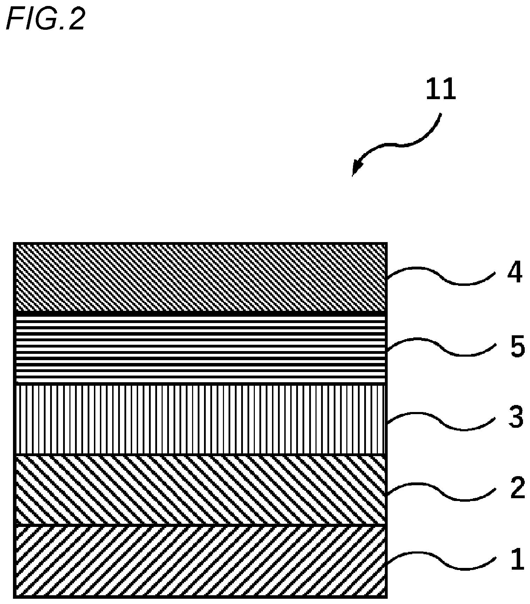

FIG. 2 is a cross-sectional view of an example of the film structure of the present invention.

A film structure 11 in FIG. 2 is the same as the film structure 10 in FIG. 1 except that the film structure 11 includes an electrode film (the first electrode film) 5 between the piezoelectric film 4 and the sacrificial layer 3. The electrode film 5 is preferably crystallized.

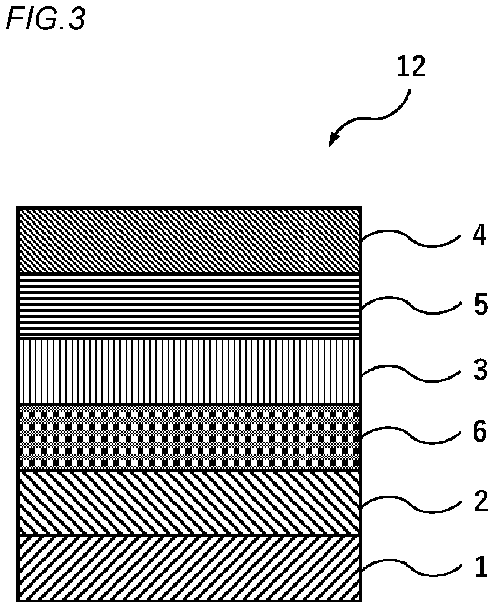

FIG. 3 is a cross-sectional view of an example of the film structure of the present invention.

A film structure 12 in FIG. 3 is the same as the film structure 11 in FIG. 2 except that the film structure 12 includes a second electrode film 6 between the zirconia-containing film 2 and the sacrificial layer 3. The second electrode film 6 is preferably crystallized.

The sacrificial layer 3 is able to be selectively removed.

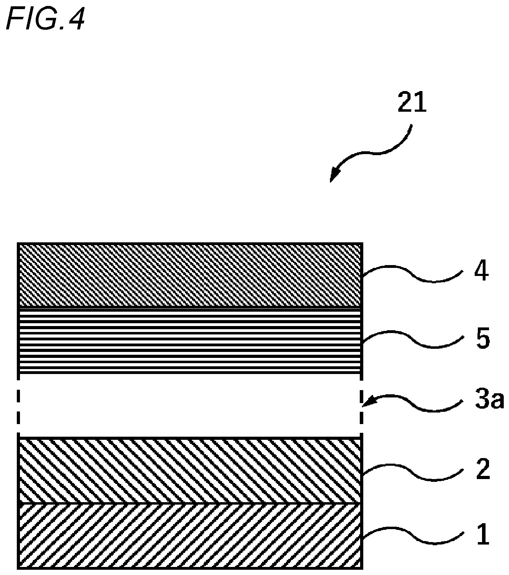

When the sacrificial layer 3 of the film structure 11 in FIG. 2 is selectively removed, a film structure 21 in FIG. 4 is obtained. The film structure 21 has a void 3a formed by selectively removing the sacrificial layer 3.

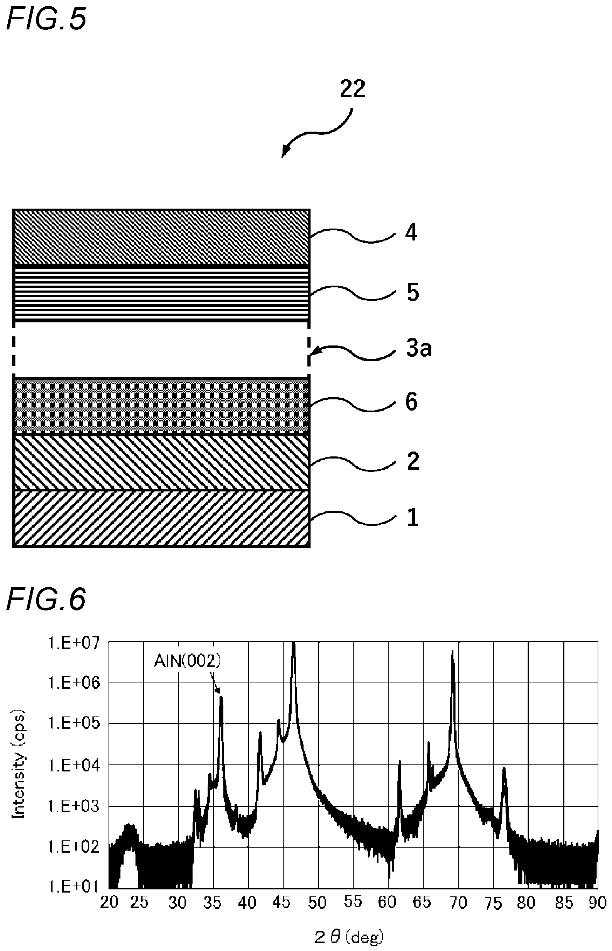

When the sacrificial layer 3 of the film structure 12 in FIG. 3 is selectively removed, a film structure 22 in FIG. 5 is obtained. The film structure 22 has the void 3a formed by selectively removing the sacrificial layer 3.

A laminate of the piezoelectric film 4 and the electrode film 5 in FIGS. 4 and 5 may be supported by a portion not shown.

### (Substrate)

The substrate is, for example, a silicon substrate made of single crystal silicon (Si). In addition to Si, for example, a silicon on insulator (SOI) substrate, a substrate made of various types of semiconductor crystals other than Si, a substrate made of various types of oxide single crystals such as sapphire, a garnet (Al₃Fe₂Si₃O₁₂) substrate, or a glass substrate having a polysilicon film formed on a front surface thereof may be used.

The substrate is single-crystallized. When the substrate is single-crystallized, it means that a main component (a component with a highest content) constituting the substrate is a single crystal.

The substrate may have any orientation, and examples of a Si substrate include Si(100), Si(110), and Si(111).

A size of the substrate is not particularly limited, and may be 10,16 cm, 15,24 cm, or 20,48 cm (4 inches, 6 inches, or 8 inches).

A thickness of the substrate is not particularly limited.

### (Zirconia-containing Film)

Typically, the zirconia-containing film (hereinafter also referred to as a "zirconia film") contains zirconia (ZrO₂) epitaxially grown on the substrate.

The zirconia film is single-crystallized. When the zirconia film is single-crystallized, it means that zirconia contained in the zirconia film is a single crystal.

It is known that a crystal system of zirconia undergoes a phase transition from a monoclinic crystal to a tetragonal crystal to a cubic crystal due to energy to be added, but any crystal structure may be used in the present invention.

A thickness of the zirconia film is not particularly limited, and is preferably 5 nm to 40 nm, and more preferably 10 nm to 30 nm.

The zirconia film may be a flat film or may be formed of a flat portion and a protruding portion. A shape of the protruding portion is not particularly limited, and examples thereof include a pyramid structure (in this case, a bottom surface of the pyramid structure is preferably in contact with the flat portion). When the zirconia film is formed of a flat portion and a protruding portion, a thickness of the flat portion is not particularly limited, and is preferably 5 nm to 25 nm, and more preferably 10 nm to 20 nm. A height of the protruding portion (a distance from the flat portion to an apex of the protruding portion) is not particularly limited, and is preferably 3 nm to 10 nm, and more preferably 4 nm to 8 nm.

The zirconia film may contain other components (for example, a rare earth element or an alkaline earth element) in addition to zirconia. Zirconia may contain oxygen defects. In order to improve characteristics, a transition metal element such as Al, Sc, Mn, Fe, Co, and Ni may be contained.

### (Sacrificial Layer)

The sacrificial layer is a film that is able to be selectively removed, and for example, is preferably a film that is able to be more selectively removed with an etchant, and is more preferably a film that is able to be more selectively removed with a liquid etchant. By selectively removing the sacrificial layer of the film structure of the present invention, a film structure in which each film is single-crystallized can be obtained.

The sacrificial layer preferably contains at least one selected from the group consisting of strontium ruthenium oxide (SRO), magnesium oxide (MgO), strontium titanate, chromium, gold, and titanium.

Typically, the sacrificial layer preferably contains strontium ruthenium oxide (SRO), magnesium oxide (MgO), strontium titanate, chromium, gold, and titanium that are epitaxially grown on the zirconia film or the second electrode film.

The sacrificial layer is single-crystallized. When the sacrificial layer is single-crystallized, it means that a main component (a component with a highest content) constituting the sacrificial layer is a single crystal. A crystal structure of the single crystal of the sacrificial layer is not particularly limited.

A thickness of the sacrificial layer is not particularly limited, and is preferably 10 nm to 70 nm, and more preferably 20 nm to 60 nm. When the thickness of the sacrificial layer is 10 nm or more, the sacrificial layer is easily selectively removed using an etchant. When the thickness of the sacrificial layer is 70 nm or less, the first electrode film formed on the sacrificial layer can be efficiently single-crystallized. Even when a piezoelectric film is further formed on the first electrode film, the piezoelectric film can be efficiently single-crystallized.

### (Piezoelectric Film)

The piezoelectric film preferably contains at least one selected from the group consisting of lead zirconate titanate (PZT), barium titanate (BaTiO₃), bismuth ferrite (BiFeO₃), aluminum nitride (AlN), lithium niobate (LiNbO₃), potassium sodium niobate, and lithium tantalate (LiTaO₃).

Typically, the piezoelectric film preferably contains a component epitaxially grown on the first electrode film.

The piezoelectric film is preferably single-crystallized. When the piezoelectric film is single-crystallized, it means that a main component (a component with a highest content) constituting the piezoelectric film is a single crystal. A crystal structure of the single crystal of the piezoelectric film is not particularly limited. For example, lead zirconate titanate (PZT), barium titanate (BaTiO₃), and potassium sodium niobate may have a perovskite structure. Bismuth ferrite (BiFeO₃), lithium niobate (LiNbO₃), and lithium tantalate (LiTaO₃) may be trigonal. Aluminum nitride (AlN) may be hexagonal.

### (First Electrode Film)

The film structure of the present invention may include the first electrode film between the piezoelectric film and the sacrificial layer.

The first electrode film preferably contains a metal, and more preferably contains at least one selected from the group consisting of platinum, copper, ruthenium, rhodium, palladium, osmium, molybdenum, and iridium.

Typically, the first electrode film preferably contains a metal epitaxially grown on the sacrificial layer.

The first electrode film is preferably single-crystallized. When the first electrode film is single-crystallized, it means that a main component (a component with a highest content) constituting the first electrode film is a single crystal. A crystal structure of the single crystal of the first electrode film is not particularly limited.

A thickness of the first electrode film is not particularly limited, and is preferably 30 nm to 500 nm, more preferably 50 nm to 450 nm, and still more preferably 100 nm to 400 nm.

The first electrode film is preferably thicker than the sacrificial layer.

### (Second Electrode Film)

The film structure of the present invention may include the second electrode film between the zirconia-containing film and the sacrificial layer.

The second electrode film preferably contains a metal, and more preferably contains at least one selected from the group consisting of platinum, copper, ruthenium, rhodium, palladium, osmium, molybdenum, and iridium.

Typically, the second electrode film preferably contains a metal epitaxially grown on the zirconia-containing film.

The second electrode film is preferably single-crystallized. When the second electrode film is single-crystallized, it means that a main component (a component with a highest content) constituting the second electrode film is a single crystal. A crystal structure of the single crystal of the second electrode film is not particularly limited.

A thickness of the second electrode film is not particularly limited, and is preferably 30 nm to 500 nm, more preferably 50 nm to 450 nm, and still more preferably 100 nm to 400 nm.

### <Method for Producing Film Structure>

A method for producing the film structure of the present invention is not particularly limited, and preferably includes: preparing a substrate, and forming, on the substrate, a zirconia-containing film, a sacrificial layer, and a piezoelectric film in this order.

Each film is preferably formed by a vapor deposition method or a sputtering method.

A film forming temperature of the sacrificial layer is preferably 565°C to 665°C. By setting the film forming temperature of the sacrificial layer within the above range, the piezoelectric film to be formed on the sacrificial layer can be efficiently single-crystalized. Even when the first electrode film is formed on the sacrificial layer, the first electrode film and the piezoelectric film to be formed thereon can be efficiently single-crystalized.

A film forming temperature of the first electrode film is preferably 300°C to 700°C, more preferably 450°C to 700°C, and particularly preferably 600°C to 700°C. By setting the film forming temperature of the first electrode film within the above range, when forming the piezoelectric film on the first electrode film, the piezoelectric film can be efficiently single-crystallized.

### <Apparatus for Producing Film Structure>

An apparatus for producing the film structure of the present invention is not particularly limited, and is preferably an apparatus for producing a film structure including: a film forming device A configured to form a zirconia-containing film; a film forming device B configured to form a sacrificial layer; and a film forming device C configured to form a piezoelectric film. The apparatus includes a controller configured to control the film forming device A, the film forming device B, and the film forming device C.

The film forming device A, the film forming device B, and the film forming device C are devices that form films by a vapor deposition method or a sputtering method.

The controller preferably includes a computer. The computer includes a CPU, a RAM, a ROM, a hard disk drive, and the like, and controls the film forming device A, the film forming device B, and the film forming device C by executing a program of film forming processing.

The apparatus for producing the film structure of the present invention may further include at least one of a film forming device D configured to form a first electrode film and a film forming device E configured to form a second electrode film. The film forming device D and the film forming device E are preferably devices that form films by a vapor deposition method or a sputtering method. The controller preferably further controls the film forming device D and the film forming device E.

### EXAMPLES

Hereinafter, the present invention will be specifically explained using Examples, but the present invention is not limited thereto.

In Examples 1 to 29 and Comparative Examples 1 to 6, the film structures 12 having the configuration shown in FIG. 3 were produced.

As the substrate 1, a 15,24 cm (6-inch) silicon single crystal wafer was used.

### (Example 1)

The zirconia film 2 was formed on the substrate 1 by an electron beam vapor deposition method.

Next, a platinum (Pt) film was formed as the second electrode film 6 on the zirconia film 2 by a sputtering method.

Next, an SRO film was formed as the sacrificial layer 3 on the second electrode film 6 by the sputtering method. A film forming temperature of the sacrificial layer 3 was 665°C. A thickness of the sacrificial layer 3 was 10 nm.

Next, a platinum (Pt) film as the electrode film (first electrode film) 5 was formed on the sacrificial layer 3 by the sputtering method. A film forming temperature of the first electrode film 5 was 700°C. A thickness of the first electrode film 5 was 50 nm.

Next, an AlN film as the piezoelectric film 4 was formed on the electrode film (the first electrode film) 5 by the sputtering method.

The formation of each film was performed with reference to the description of Examples in Japanese Patent No. 6498821 B1.

In this way, a film structure in Example 1 was produced.

### (Examples 2 to 18, Comparative Examples 1 to 6)

Film structures in Examples 2 to 18 and Comparative Examples 1 to 6 were produced in the same manner as in Example 1 except that a thickness of the sacrificial layer 3 and a thickness of the first electrode film 5 were changed to values shown in the following Table 1.

**[Table 1]**

| Film forming temperature of sacrificial layer: 665°C Film forming temperature of first electrode film: 700°C | | Thickness (nm) of first electrode film | | |
|---|---|---|---|---|
| | | 50 | 150 | 400 |
| | 5 | Comparative Example 1 | Comparative Example 2 | Comparative Example 3 |
| | 10 | Example 1 | Example 2 | Example 3 |
| | 20 | Example 4 | Example 5 | Example 6 |
| Thickness (nm) of sacrificial layer | 30 | Example 7 | Example 8 | Example 9 |
| | 40 | Example 10 | Example 11 | Example 12 |
| | 50 | Example 13 | Example 14 | Example 15 |
| | 70 | Example 16 | Example 17 | Example 18 |
| | 100 | Comparative Example 4 | Comparative Example 5 | Comparative Example 6 |

### (Examples 19 to 29)

Film structures in Examples 19 to 29 and Comparative Example 7 were produced in the same manner as in Example 1 except that a film forming temperature of the sacrificial layer 3 and a film forming temperature of the first electrode film 5 were changed to values shown in the following Table 2, and a thickness of the sacrificial layer 3 and a thickness of the first electrode film 5 were changed as follows.
Example 19: thickness of sacrificial layer 40 nm, thickness of first electrode film 150 nm
Example 20: thickness of sacrificial layer 10 nm, thickness of first electrode film 150 nm
Example 21: thickness of sacrificial layer 10 nm, thickness of first electrode film 150 nm
Example 22: thickness of sacrificial layer 10 nm, thickness of first electrode film 150 nm
Example 23: thickness of sacrificial layer 40 nm, thickness of first electrode film 150 nm
Example 24: thickness of sacrificial layer 10 nm, thickness of first electrode film 150 nm
Example 25: thickness of sacrificial layer 10 nm, thickness of first electrode film 150 nm
Example 26: thickness of sacrificial layer 10 nm, thickness of first electrode film 150 nm
Example 27: thickness of sacrificial layer 10 nm, thickness of first electrode film 150 nm
Example 28: thickness of sacrificial layer 10 nm, thickness of first electrode film 150 nm
Example 29: thickness of sacrificial layer 10 nm, thickness of first electrode film 150 nm

**[Table 2]**

| | | Film forming temperature (°C) of first electrode film | | | | | | |
|---|---|---|---|---|---|---|---|---|
| | | 300 | 400 | 450 | 500 | 600 | 650 | 700 |
| Film forming temperature (°C) of sacrificial layer | 565 | Example 19 | - | - | - | Example 20 | Example 21 | Example 22 |
| | 615 | - | - | Example 23 | - | - | - | - |
| | 665 | Example 24 | Example 25 | Example 26 | Example 27 | Example 28 | Example 29 | - |

### <Evaluation of Crystallinity>

### (θ-2θ spectrum Obtained by XRD Method)

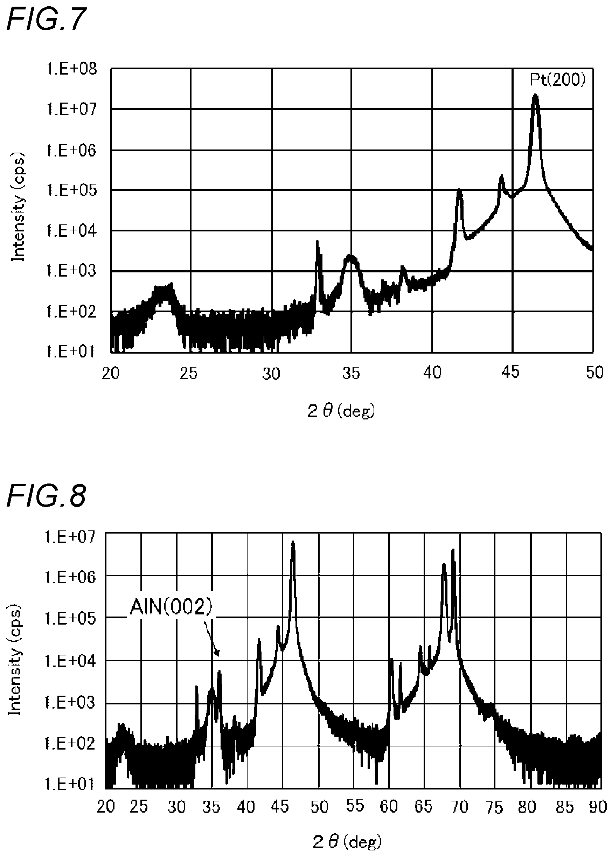

FIG. 6 and FIG. 7 are graphs showing θ-2θ spectra of the film structure in Example 1, which are obtained by an XRD method. In FIG. 6, a peak corresponding to a (002) plane of AlN having a hexagonal crystal structure was observed, and in FIG. 7, a peak corresponding to a (200) plane of Pt having a cubic crystal structure was observed.

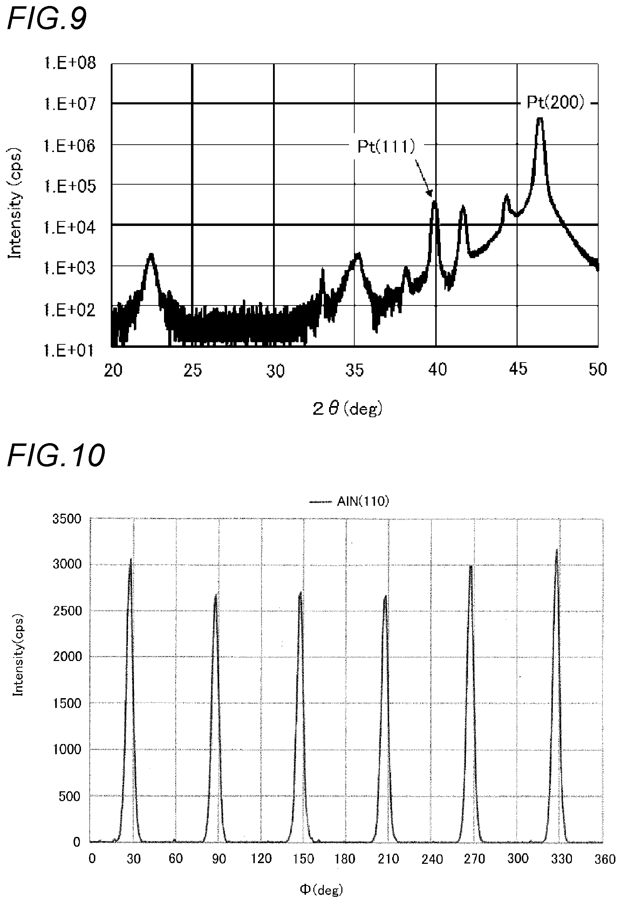

FIG. 8 and FIG. 9 are graphs showing θ-2θ spectra of the film structure in Comparative Example 4, which are obtained by the XRD method. In FIG. 8, a peak of AlN(002) was weaker than that in Example 1. It can be said that when the peak of AlN(002) is weak, an abundance ratio of AlN(002) is low and crystallinity is low (many are not crystallized). In FIG. 9, a peak of Pt(111) is observed, and since two peaks are observed, crystals are mixed and cannot be considered a single crystal.

From the above, it was found that Example 1 had a crystal structure better than that in Comparative Example 4.

When θ-2θ spectra in Examples 2 to 29 and Comparative Examples 1 to 3 were measured by the XRD method, results were similar to those in Example 1.

When θ-2θ spectra in Comparative Examples 5 and 6 were measured by the XRD method, results were similar to those in Comparative Example 4.

### (X-ray diffraction pattern obtained by Φ scan)

FIG. 10 shows an X-ray diffraction pattern of a piezoelectric film of the film structure in Example 1, which is obtained by Φ scan. From FIG. 10, it was found that the piezoelectric film of the film structure in Example 1 was single-crystallized.

When X-ray diffraction patterns of piezoelectric films were measured by Φ scan for Examples 2 to 29 and Comparative Examples 1 to 3, results were similar to those in Example 1.

In Examples 1 to 29 and Comparative Examples 1 to 3, the substrate and all the films provided in the film structure were single-crystallized.

When X-ray diffraction patterns of piezoelectric films were measured by Φ scan for Comparative Examples 4 to 6, it was found that the substrate and all the films provided in the film structure were not single-crystallized.

### <Evaluation of Whether Sacrificial Layer can be Selectively Removed (Selective Removal of Sacrificial Layer)>

Using a cerium nitrate aqueous solution as an etchant, attempts were made to selectively remove sacrificial layers of the film structures in Examples 1 to 29 and Comparative Examples 1 to 6. A side etching rate (µm/minute) was measured.

A relationship between the thickness of the sacrificial layer and the side etching rate (µm/minute) is shown in the following Table 3. In Table 3, "-" indicates that removal was not possible.

**[Table 3]**

| | | | | | |
|---|---|---|---|---|---|
| Thickness (nm) of sacrificial layer | 5 | 10 | 40 | 70 | 100 |
| Side etching rate (µm/minute) | - | 10 | 170 | 170 | 170 |

From Table 3, it was found that when the thickness of the sacrificial layer was 10 nm or more (Examples 1 to 29 and Comparative Examples 4 to 6), the side etching rate was good and the sacrificial layer could not be selectively removed. It was found that when the thickness of the sacrificial layer was 5 nm (Comparative Examples 1 to 3), the side etching rate was small and the sacrificial layer could not be selectively removed.

The above results are summarized in the following Table 4. "A" indicates that the result is good, "B" indicates that the result is inferior to "A" but within the allowable range, and "C" indicates that the result is poor.

**[Table 4]**

| | Crystallinity of first electrode film | Crystallinity of piezoelectric film | Selective removal of sacrificial layer |
|---|---|---|---|
| Example 1 | A | A | A |
| Example 2 | A | A | A |
| Example 3 | A | A | A |
| Example 4 | A | A | A |
| Example 5 | A | A | A |
| Example 6 | A | A | A |
| Example 7 | A | A | A |
| Example 8 | A | A | A |
| Example 9 | A | A | A |
| Example 10 | A | A | A |
| Example 11 | A | A | A |
| Example 12 | A | A | A |
| Example 13 | A | A | A |
| Example 14 | A | A | A |
| Example 15 | A | A | A |
| Example 16 | A | A | A |
| Example 17 | A | A | A |
| Example 18 | A | A | A |
| Example 19 | B | B | A |
| Example 20 | B | B | A |
| Example 21 | A | A | A |
| Example 22 | A | A | A |
| Example 23 | A | A | A |
| Example 24 | B | B | A |
| Example 25 | B | B | A |
| Example 26 | A | A | A |
| Example 27 | A | A | A |
| Example 28 | A | A | A |
| Example 29 | A | A | A |
| Comparative Example 1 | A | A | C |
| Comparative Example 2 | A | A | C |
| Comparative Example 3 | A | A | C |
| Comparative Example 4 | C | C | A |
| Comparative Example 5 | C | C | A |
| Comparative Example 6 | C | C | A |

### INDUSTRIAL APPLICABILITY

The film structure of the present invention is a film structure which has a void between a substrate and an electrode film and in which each film provided in the film structure is single-crystallized, so that the film structure can be used as various types of MEMS such as FBAR.

### REFERENCE SIGNS LIST

1: Substrate
2: Zirconia-containing film
3: Sacrificial layer
4: Piezoelectric film
5: First electrode film
6: Second electrode film
3a: Void
10, 11, 12: Film structure
21, 22: Film structure having void

## Claims

1. A film structure (21, 22) obtainable by the following process:
producing a first film structure (10, 11, 12) comprising: a substrate (1); a zirconia-containing film (2); a sacrificial layer (3); and a piezoelectric film (4), in this order, wherein
the substrate (1), the zirconia-containing film (2), the sacrificial layer (3), and the piezoelectric film (4) are each single crystalline, and
selectively removing the sacrificial layer (3) from the first film structure (10, 11, 12).

2. The film structure (21, 22) according to claim 1, wherein the first film structure (10, 11, 12) further comprises: a first electrode film (5) between the piezoelectric film (4) and the sacrificial layer (3).

3. The film structure (21, 22) according to claim 1 or 2, wherein the piezoelectric film (4) contains at least one selected from the group consisting of lead zirconate titanate, barium titanate, bismuth ferrite, aluminum nitride, lithium niobate, potassium sodium niobate, and lithium tantalate.

4. The film structure (21, 22) according to claim 2, wherein the first electrode film (5) is single-crystallized.

5. The film structure (21, 22) according to any one of claims 1 to 4, wherein the sacrificial layer (3) contains at least one selected from the group consisting of strontium ruthenium oxide, magnesium oxide, strontium titanate, chromium, gold, and titanium.

6. The film structure (21, 22) according to claim 2 or 4, wherein the first electrode film (5) contains at least one selected from the group consisting of platinum, copper, ruthenium, rhodium, palladium, osmium, molybdenum, and iridium.

7. The film structure (21, 22) according to claim 2, 4 or 6, wherein the electrode film is thicker than the sacrificial layer (3).

8. The film structure (21, 22) according to any one of claims 1 to 7, wherein the sacrificial layer (3) has a thickness of 10 nm to 70 nm.

9. The film structure (21, 22) according to any one of claims 1 to 8,wherein the first film structure (10, 11, 12) further comprises: a second electrode film (6) between the zirconia-containing film (2) and the sacrificial layer (3).

10. The film structure (21, 22) according to claim 9, wherein the second electrode film (6) is single crystalline.

11. A method for producing the first film structure (10, 11, 12) according to any one of claims 1 to 10, the method comprising:
preparing a substrate (1); and
forming, on the substrate (1), a zirconia-containing film (2), a sacrificial layer (3), and a piezoelectric film (4), in this order, wherein
a film forming temperature of the sacrificial layer (3) is 565°C to 665°C.

12. An apparatus for producing the first film structure (10, 11, 12) according to any one of claims 1 to 10, the apparatus comprising:
a film forming device A configured to form a zirconia-containing film (2); a film forming device B configured to form a sacrificial layer (3); and a film forming device C configured to form a piezoelectric film (4), wherein
the apparatus includes a controller configured to control the film forming device A, the film forming device B, and the film forming device C.

## Patentansprüche

1. Filmstruktur (21, 22), die durch das folgende Verfahren erhältlich ist:
Herstellen einer ersten Filmstruktur (10, 11, 12), die umfasst: ein Substrat (1); einen zirkoniumdioxidhaltigen Film (2); eine Opferschicht (3); und einen piezoelektrischen Film (4) in dieser Reihenfolge, wobei
das Substrat (1), der zirkoniumdioxidhaltige Film (2), die Opferschicht (3) und der piezoelektrische Film (4) jeweils einkristallin sind, und
selektives Entfernen der Opferschicht (3) von der ersten Filmstruktur (10, 11, 12).

2. Filmstruktur (21, 22) gemäß Anspruch 1, wobei die erste Filmstruktur (10, 11, 12) ferner umfasst: einen ersten Elektrodenfilm (5) zwischen dem piezoelektrischen Film (4) und der Opferschicht (3).

3. Filmstruktur (21, 22) gemäß Anspruch 1 oder 2, wobei der piezoelektrische Film (4) mindestens einen Stoff enthält, der aus der Gruppe ausgewählt ist, die aus Bleizirkonattitanat, Bariumtitanat, Bismutferrit, Aluminiumnitrid, Lithiumniobat, Kaliumnatriumniobat und Lithiumtantalat besteht.

4. Filmstruktur (21, 22) gemäß Anspruch 2, wobei der erste Elektrodenfilm (5) einkristallisiert ist.

5. Filmstruktur (21, 22) gemäß einem der Ansprüche 1 bis 4, wobei die Opferschicht (3) mindestens eines enthält, das aus der Gruppe ausgewählt ist, die aus Strontiumrutheniumoxid, Magnesiumoxid, Strontiumtitanat, Chrom, Gold und Titan besteht.

6. Filmstruktur (21, 22) gemäß Anspruch 2 oder 4, wobei der erste Elektrodenfilm (5) mindestens eines enthält, das aus der Gruppe ausgewählt ist, die aus Platin, Kupfer, Ruthenium, Rhodium, Palladium, Osmium, Molybdän und Iridium besteht.

7. Filmstruktur (21, 22) gemäß Anspruch 2, 4 oder 6, wobei der Elektrodenfilm dicker ist als die Opferschicht (3).

8. Filmstruktur (21, 22) gemäß einem der Ansprüche 1 bis 7, wobei die Opferschicht (3) eine Dicke von 10 nm bis 70 nm aufweist.

9. Filmstruktur (21, 22) gemäß einem der Ansprüche 1 bis 8, wobei die erste Filmstruktur (10, 11, 12) ferner umfasst: einen zweiten Elektrodenfilm (6) zwischen dem zirkoniumhaltigen Film (2) und der Opferschicht (3).

10. Filmstruktur (21, 22) gemäß Anspruch 9, wobei der zweite Elektrodenfilm (6) einkristallin ist.

11. Verfahren zur Herstellung der ersten Filmstruktur (10, 11, 12) gemäß einem der Ansprüche 1 bis 10, wobei das Verfahren umfasst:
Herstellen eines Substrats (1); und
Bilden einer zirkoniumdioxidhaltigen Schicht (2), einer Opferschicht (3) und einer piezoelektrischen Schicht (4) in dieser Reihenfolge auf dem Substrat (1), wobei
die Filmbildungstemperatur der Opferschicht (3) 565°C bis 665°C beträgt.

12. Vorrichtung zur Herstellung der ersten Filmstruktur (10, 11, 12) gemäß einem der Ansprüche 1 bis 10, wobei die Vorrichtung umfasst:
eine Filmbildungsvorrichtung A, die zum Bilden eines zirkoniumhaltigen Films (2) konfiguriert ist; eine Filmbildungsvorrichtung B, die zum Bilden einer Opferschicht (3) konfiguriert ist; und eine Filmbildungsvorrichtung C, die zum Bilden eines piezoelektrischen Films (4) konfiguriert ist, wobei
die Vorrichtung eine Steuereinheit umfasst, die so konfiguriert ist, dass sie die Filmbildungsvorrichtung A, die Filmbildungsvorrichtung B und die Filmbildungsvorrichtung C steuert.

## Revendications

1. Structure de film (21, 22) pouvant être obtenue par le procédé suivant :
produire d'une première structure de film (10, 11, 12) comprenant : un substrat (1) ; un film contenant de la zircone (2) ; une couche sacrificielle (3) ; et un film piézoélectrique (4), dans cet ordre, dans laquelle
le substrat (1), le film contenant de la zircone (2), la couche sacrificielle (3) et le film piézoélectrique (4) sont chacun monocristallins, et
retirer de manière sélective la couche sacrificielle (3) de la première structure de film (10, 11, 12).

2. Structure de film (21, 22) selon la revendication 1, dans laquelle la première structure de film (10, 11, 12) comprend en outre : un premier film d'électrode (5) entre le film piézoélectrique (4) et la couche sacrificielle (3).

3. Structure de film (21, 22) selon la revendication 1 ou 2, dans laquelle le film piézoélectrique (4) contient au moins un élément/composé choisi parmi le groupe comprenant le titanate de zirconate de plomb, le titanate de baryum, le ferrite de bismuth, le nitrure d'aluminium, le niobate de lithium, le niobate de potassium et de sodium, et le tantalate de lithium.

4. Structure de film (21, 22) selon la revendication 2, dans laquelle le premier film d'électrode (5) est monocristallisé.

5. Structure de film (21, 22) selon l'une quelconque des revendications 1 à 4, dans laquelle la couche sacrificielle (3) contient au moins un élément/composé choisi parmi le groupe constitué d'oxyde de strontiumruthénie, d'oxyde de magnésium, de titanate de strontium, de chrome, d'or et de titane.

6. Structure de film (21, 22) selon la revendication 2 ou 4, dans laquelle le premier film d'électrode (5) contient au moins un élément choisi parmi le groupe constitué de platine, de cuivre, de ruthénium, de rhodium, de palladium, d'osmium, de molybdène et d'iridium.

7. Structure de film (21, 22) selon la revendication 2, 4 ou 6, dans laquelle le film d'électrode est plus épais que la couche sacrificielle (3).

8. Structure de film (21, 22) selon l'une quelconque des revendications 1 à 7, dans laquelle la couche sacrificielle (3) a une épaisseur de 10 nm à 70 nm.

9. Structure de film (21, 22) selon l'une quelconque des revendications 1 à 8, dans laquelle la première structure de film (10, 11, 12) comprend en outre : un deuxième film d'électrode (6) entre le film contenant de la zircone (2) et la couche sacrificielle (3).

10. Structure de film (21, 22) selon la revendication 9, dans laquelle le deuxième film d'électrode (6) est monocristallin.

11. Procédé de fabrication de la première structure de film (10, 11, 12) selon l'une quelconque des revendications 1 à 10, le procédé comprenant :
préparer un substrat (1) ; et
former, sur le substrat (1), un film contenant de la zircone (2), une couche sacrificielle (3) et un film piézoélectrique (4), dans cet ordre, dans lequel
la température de formation du film de la couche sacrificielle (3) est comprise entre 565°C et 665°C.

12. Appareil pour produire la première structure de film (10, 11, 12) selon l'une quelconque des revendications 1 à 10, l'appareil comprenant :
un dispositif de formation de film A configuré pour former un film contenant de la zircone (2) ; un dispositif de formation de film B configuré pour former une couche sacrificielle (3) ; et un dispositif de formation de film C configuré pour former un film piézoélectrique (4), dans lequel
l'appareil comprend un contrôleur configuré pour contrôler le dispositif de formation de film A, le dispositif de formation de film B et le dispositif de formation de film C.
